## Europäisches Patentamt
## European Patent Office
## Office européen des brevets

(19)

(11) Numéro de publication : **0 164 281**
**B1**

(12)

# FASCICULE DE BREVET EUROPÉEN

(45) Date de publication du fascicule du brevet :
**01.02.89**

(51) Int. Cl.⁴ : **H 01 L 21/76, H 01 L 21/265, H 01 L 21/316**

(21) Numéro de dépôt : **85400773.9**

(22) Date de dépôt : **18.04.85**

(54) **Procédé de fabrication d'une couche isolante enterrée dans un substrat semiconducteur, par implantation ionique.**

(30) Priorité : **19.04.84 FR 8406232**

(43) Date de publication de la demande :
**11.12.85 Bulletin 85/50**

(45) Mention de la délivrance du brevet :
**01.02.89 Bulletin 89/05**

(84) Etats contractants désignés :
**CH DE GB LI**

(56) Documents cités :
**FR--A-- 2 410 364**
**US--A-- 4 361 600**
**US--A-- 4 412 868**
**IBM TECHNICAL DISCLOSURE BULLETIN, vol. 26, no. 2, juillet 1983, pages 621-622, New York, US; P.H. PAN et al.: "Bird's beak-free recessed oxide isolation by O2 ion implantation"**
**PATENTS ABSTRACTS OF JAPAN, vol. 5, no. 133 (E-71), page 805, 25 aôut 1981; & JP - A - 56 70645 (CHO LSI GIJUTSU KENKYU KUMIAI) 12-06-1981**
**IEEE TRANSACTIONS ON ELECTRON DEVICES, vol. ED-30, no. 11, novembre 1983, pages 1515-1520, New York, US; G. ZIMMER et al.: "CMOS on buried nitride-A VLSI SOI technology"**
**Le dossier contient des informations techniques présentées postérieurement au dépôt de la demande et ne figurant pas dans le présent fascicule.**

(73) Titulaire : **COMMISSARIAT A L'ENERGIE ATOMIQUE**
**31/33, rue de la Fédération**
**F-75015 Paris (FR)**

(72) Inventeur : **Bruel, Michel**
**Presvert No 9**
**F-38113 Veurey (FR)**
Inventeur : **du Port De Poncharra, Jean**
**Quaix-En-Chartreuse**
**F-38950 Saint Martin-Le-Vinoux (FR)**

(74) Mandataire : **Mongrédien, André et al**
**c/o BREVATOME 25, rue de Ponthieu**
**F-75008 Paris (FR)**

**EP 0 164 281 B1**

## Description

La présente invention a pour objet un procédé de fabrication d'une couche isolante enterrée dans un substrat semiconducteur, par implantation ionique. Elle s'applique en particulier dans le domaine de la fabrication des circuits intégrés MOS du type silicium sur isolant.

La technologie silicium sur isolant ou technologie SSI constitue une amélioration sensible par rapport aux techniques standard dans lesquelles les composants actifs des circuits intégrés sont réalisés directement sur un substrat monocristallin en silicium massif. En effet, l'emploi d'un support isolant conduit à une forte diminution des capacités parasites entre la source et le substrat d'une part, et le drain et le substrat d'autre part, des composants actifs des circuits et donc à un accroissement de la vitesse de fonctionnement de ces circuits ; il conduit aussi à une simplification notable des procédés de fabrication, à une augmentation de la densité d'intégration, à une meilleure tenue des circuits aux hautes tensions et à une faible sensibilité aux rayonnements du fait que le volume de silicium monocristallin est faible. De plus, cette technologie permet d'obtenir des ilots de silicium monocristallin, isolés les uns des autres, dans lesquels peuvent être réalisés les différents composants actifs d'un circuit intégré.

L'une des technologies SSI connue actuellement est la technologie SOS (Silicon On Sapphire en terminologie anglo-saxonne), dans laquelle les composants sont réalisés dans une couche mince de silicium, épitaxiée sur un substrat isolant en saphir. Cette technologie présente plusieurs inconvénients ; en particulier, le coût du substrat en saphir est élevé et l'épitaxie de la couche mince sur le substrat est difficile à réaliser. De plus, cette couche mince de silicium présente un grand nombre de défauts résultant de son procédé d'obtention.

Pour remédier à ces inconvénients, d'autres technologies ont été recherchées. Parmi ces technologies, on peut citer celles faisant appel à la recristallisation d'une couche de silicium amorphe ou polycristallin, déposée sur un substrat amorphe tel que de l'oxyde de silicium. La recristallisation du silicium se fait en utilisant des lampes, des lasers ou des éléments chauffants permettant d'apporter la chaleur nécessaire à la fusion du silicium amorphe ou polycristallin. Cette technologie présente malheureusement des inconvénients liés notamment à la mauvaise qualité de l'interface silicium-isolant (canal parasite à l'interface par exemple).

D'autres technologies basées sur la réalisation du matériau isolant a posteriori, c'est-à-dire à partir du silicium monocristallin massif, ont été envisagées. Parmi celles-ci, on peut citer le procédé consistant à implanter des ions d'oxygène ou d'azote à forte dose dans du silicium monocristallin massif permettant de former, après un recuit du substrat à haute température, une couche isolante enterrée d'oxyde de silicium ou de nitrure de silicium. Ce procédé connu sous le nom de procédé SIMOX (Separation by Implanted Oxygen en terminologie anglo-saxonne) est notamment décrit dans un article de P.L.F. HEMMENT et al de Nuclear Instruments and Methods 209/210 de 1983, pages 157-164, intitulé « Formation of buried insulating layers in silicon by the implantation of high doses of oxygen ».

Cependant, dans ce procédé SIMOX, le passage des ions d'oxygène ou d'azote endommage plus ou moins la couche de silicium monocristallin surmontant la couche isolante et en particulier dans les régions de cette couche de silicium où seront réalisées les zones actives des composants actifs des circuits intégrés ; les défauts créés sont néfastes pour obtenir un bon fonctionnement des composants.

La présente invention a justement pour objet un procédé de fabrication d'une couche isolante enterrée dans un substrat semi-conducteur, notamment en silicium monocristallin, permettant de remédier aux différents inconvénients donnés précédemment. Ce procédé basé sur l'emploi d'une implantation ionique d'ions d'oxygène ou d'azote dans le substrat semi-conducteur permet notamment d'obtenir une couche semi-conductrice monocristalline surmontant une couche isolante enterrée, exempte de défauts, dans les régions de la couche semi-conductrice où seront réalisées les zones actives des composants des circuits intégrés.

De façon plus précise, l'invention a pour objet un procédé de fabrication d'une couche isolante continue enterrée dans un substrat semi-conducteur dans lequel seront réalisées les zones actives des composants actifs d'un circuit intégré, consistant à réaliser un masque sur chaque région du substrat dans lesquelles seront réalisées les zones actives, à implanter des ions d'oxygène ou d'azote dans le substrat, à travers le masque pour former respectivement une couche isolante d'oxyde ou de nitrure continue et enterrée dans ledit substrat, par dispersion et diffusion latérales des ions dans ledit substrat, l'énergie et la dose d'implantation étant respectivement au moins égales à 200 keV et $10^{18}$ ions/cm$^2$, à chauffer le substrat pendant l'implantation afin de faciliter ladite diffusion et à effectuer, après implantation, un recuit du substrat implanté servant à renforcer, par diffusion latérale des ions implantés, la continuité de la couche isolante et à recristalliser à partir desdites régions du substrat, les parties du substrat perturbées lors de l'implantation.

Le masquage des régions du substrat dans lesquelles seront réalisées les zones actives des composants d'un circuit intégré permet d'éviter toute détérioration desdites zones actives, lors de l'implantation ionique.

Par zone active d'un composant, il faut comprendre la zone de canal de ce composant, c'est-à-dire la zone située sous la grille du composant.

Selon un mode préféré de mise en œuvre du procédé de l'invention, on effectue, pendant

2

l'implantation ionique, le chauffage du substrat, à une température d'environ 500 °C.

Selon un autre mode préféré de mise en œuvre du procédé de l'invention, on réalise l'implantation ionique avec un faisceau d'ions de forte énergie, c'est-à-dire présentant une énergie variant entre 200 et 1 000 KeV. De préférence, cette implantation ionique est réalisée à une dose de quelques $10^{18}$ atomes/cm$^2$.

Le procédé de fabrication d'une couche isolante continue enterrée selon l'invention s'applique avantageusement pour la réalisation sur un support isolant d'un composant actif d'un circuit intégré. Dans cette application, le procédé de l'invention se caractérise en ce qu'il comprend les étapes suivantes :

réalisation d'une couche d'oxyde sur le substrat constituant l'oxyde de grille du composant,

dépôt sur la couche d'oxyde de grille d'une couche conductrice servant à réaliser l'électrode de grille du composant,

dépôt sur la couche conductrice d'une couche d'isolant,

gravure de la couche d'isolant déposée, puis gravure de la couche conductrice afin de réaliser la grille du composant,

implantation ionique d'oxygène ou d'azote dans le substrat servant à former, par dispersion et diffusion latérales dans ledit substrat des ions implantés, une couche isolante d'oxyde ou de nitrure continue et enterrée dans ledit substrat, la couche conductrice et la couche d'isolant gravées servant de masque à cette implantation

chauffage du substrat pendant l'implantation ionique et,

réalisation d'un recuit du substrat implanté servant à renforcer, par diffusion latérale des ions implantés, la continuité de la couche isolante d'oxyde ou de nitrure enterrée dans ledit substrat.

Ce recuit, à haute température permet, d'autre part, d'assurer une recristallisation latérale du substrat endommagé par le passage des ions, la zone active du composant, située sous la grille, servant de germe de départ à cette recristallisation.

Selon un mode préféré de mise en œuvre de ce procédé, le masque et en particulier la grille du composant actif présente une largeur allant de 0,5 à 5 µm ; la largeur de grille correspond à la longueur du canal du composant.

De façon avantageuse, le substrat semi-conducteur est réalisé en silicium monocristallin.

Dans l'application du procédé de l'invention, pour la réalisation d'un composant actif, la couche d'isolant est avantageusement réalisée en oxyde de silicium ou en nitrure de silicium.

D'autres caractéristiques et avantages de l'invention ressortiront mieux de la description qui va suivre, donnée à titre explicatif et non limitatif en référence aux figures annexées, dans lesquelles :

les figures 1 à 3 représentent schématiquement en coupe longitudinale, les différentes étapes du procédé de fabrication d'une couche isolante enterrée dans un substrat semiconducteur, conformément à l'invention, et

la figure 4 représente schématiquement, en coupe longitudinale, la réalisation d'îlots semiconducteurs sur une couche isolante obtenue selon le procédé de l'invention.

La description qui va suivre se rapporte à un procédé de fabrication d'une couche isolante enterrée dans un substrat semiconducteur monocristallin en silicium pour la réalisation d'un transistor MOS d'un circuit intégré du type silicium sur isolant. Mais bien entendu, l'invention est d'application beaucoup plus générale.

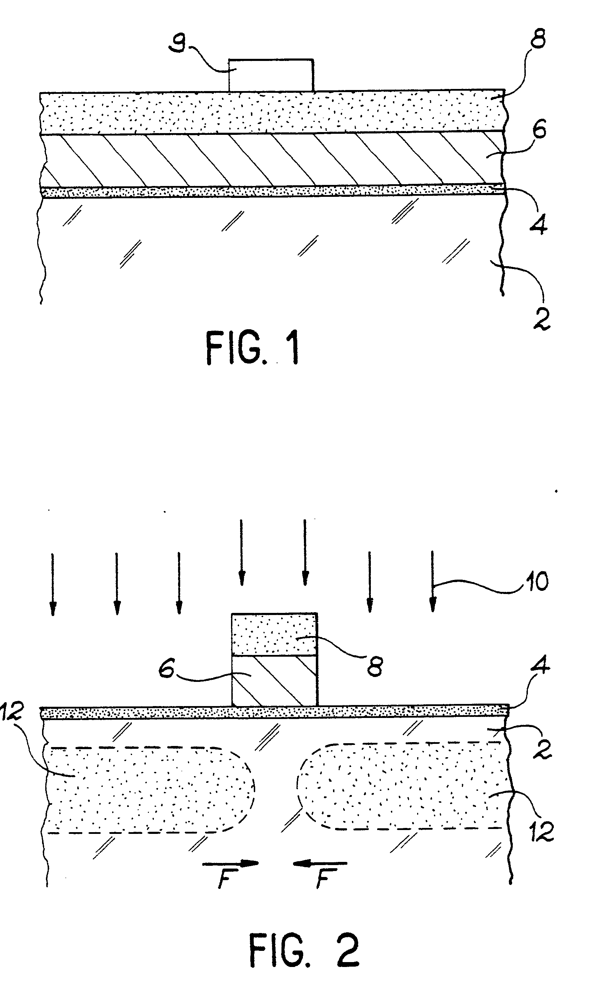

Comme représenté sur la figure 1, on réalise tout d'abord sur un substrat semiconducteur en silicium monocristallin 2 une couche d'oxyde 4. Cette couche 4 peut être obtenue par oxydation thermique du substrat à une température d'environ 900 °C. Cette couche d'oxyde 4, présentant par exemple une épaisseur de 30 nm (300 Å), constitue l'oxyde de grille d'un transistor MOS qui sera réalisé ultérieurement.

Sur cette couche d'oxyde 4, on réalise ensuite le dépôt d'une couche conductrice 6 dans laquelle sera réalisée l'électrode de grille du transistor. Cette couche conductrice 6, présentant par exemple une épaisseur de 0,4 µm, peut être réalisée en silicium polycristallin dopé. Le dépôt de cette couche 6 est réalisé par exemple par la technique de dépôt chimique en phase vapeur, à basse pression ou non.

On dépose ensuite sur la couche conductrice 6 une couche isolante 8 réalisée de préférence en oxyde de silicium ou en nitrure de silicium. Cette couche d'isolant 8, présentant une épaisseur fonction de l'énergie d'implantation, réalisée ultérieurement, peut être obtenue par la technique de dépôt chimique en phase vapeur, à basse pression ou non.

Après le dépôt de la couche d'isolant 8, on réalise, par les procédés classiques de la microlithographie, un masque 9 en résine sur ladite couche d'isolant servant à définir les dimensions de la grille du transistor et en particulier la longueur de la grille, celle-ci étant de préférence comprise entre 0,5 et 5 µm.

On réalise ensuite, comme représenté sur la figure 2, une gravure de la couche d'isolant 8, puis une gravure de la couche conductrice 6 afin de réaliser la grille du transistor. Ces gravures peuvent être réalisées successivement ou simultanément par exemple par un procédé de gravure ionique réactive en utilisant par exemple comme agent d'attaque, de l'hexafluorure de soufre ($SF_6$).

Après réalisation de ces gravures, puis élimination du masque 9, par exemple par attaque chimique, on implante des ions d'oxygène ou d'azote dans le substrat semiconducteur 2. La couche isolante 8 et la couche conductrice 6 gravées, servant de masque à cette implantation, permettent d'éviter toute détérioration de la zone active du transistor (zone du canal), lors de l'implantation. Cette implantation ionique, portant la référence 10, est réalisée de préférence avec un faisceau d'ions présentant une énergie variant entre 200 et 1 000 KeV et à forte dose, c'est-à-dire à une dose allant de $10^{18}$ à $3.10^{18}$ atomes/cm$^2$. Elle permet d'obtenir des régions isolantes 12 dans le substrat 2. Ces régions isolantes 12 sont en oxyde de silicium, lorsque l'on utilise une implantation d'ions d'oxygène, et en nitrure de silicium lorsque l'on utilise une implantation d'ions d'azote.

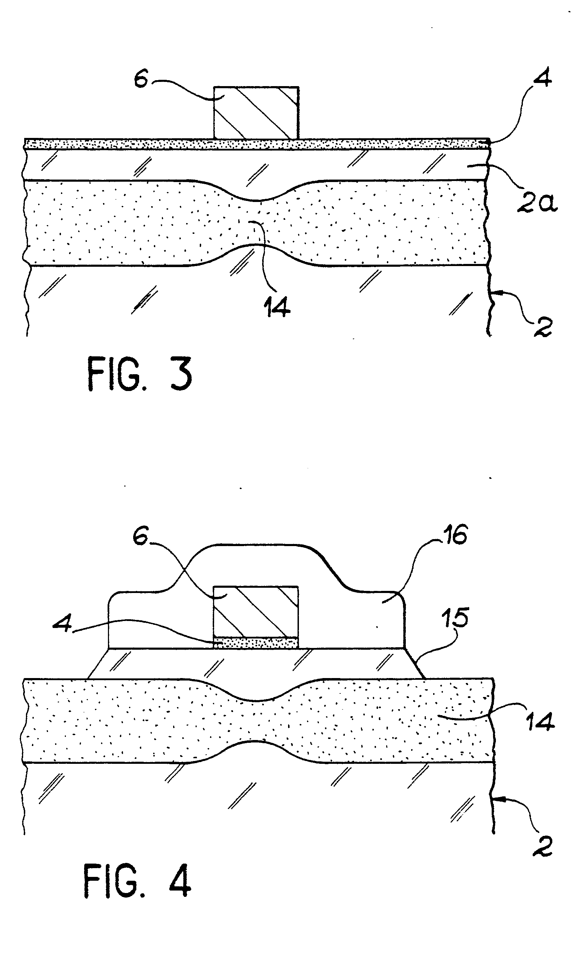

Etant donné que la grille du transistor, réalisée dans la couche conductrice 6, présente une largeur relativement faible ($\leqslant 5$ $\mu$m), on utilise le phénomène d'étalement latéral, c'est-à-dire de dispersion et de diffusion latérales dans le substrat, des ions d'oxygène ou d'azote implantés, schématisé par les flèches F sur la figure 2, pour obtenir une couche isolante enterrée 14 dans le substrat 2, comme représenté sur la figure 3.

Afin de faciliter la diffusion des ions implantés dans le substrat, on effectue, au cours de l'implantation, un chauffage à température modérée du substrat et par exemple à une température de l'ordre de 500 °C.

Après l'implantation ionique puis l'élimination de la couche d'isolant gravée 8, par exemple par un procédé de gravure ionique réactive avec du $SF_6$, on réalise un recuit du substrat implanté servant à renforcer la continuité de la couche isolante enterrée 14 par diffusion des ions d'oxygène ou d'azote implantés. De plus, ce recuit permet d'assurer une certaine recristallisation des zones du substrat endommagées lors de l'implantation ionique, et donc une guérison des défauts et augmentation de leur qualité électrique, la zone active du composant, non perturbée par l'implantation grâce au masque (couche isolante 8 et couche conductrice 6 gravées) servant de germe à cette recristallisation. Le recuit est par exemple réalisé à haute température, c'est-à-dire entre 1 000 et 1 200 °C et par exemple à 1 100 °C.

L'obtention d'une couche isolante enterrée 14 par étalement latéral des ions implantés (figure 2) et diffusion de ceux-ci, lors du recuit, dépend de l'énergie des ions implantés. De plus, la profondeur à laquelle cette couche isolante est réalisée ainsi que son épaisseur dépendent de cette énergie.

Le tableau suivant donne la profondeur moyenne $R_p$ en $\mu$m du maximum de concentration des ions d'oxygène et d'azote implantés dans un substrat en silicium monocristallin ainsi que l'écart-type $\Delta R_p$ en $\mu$m en fonction des énergies en keV utilisées pour l'implantation.

Tableau

| Energie (keV) | $O^+/Si$ | | $N^+/Si$ | |
|---|---|---|---|---|
| | $R_p$ ($\mu$m) | $\Delta R_p$ ($\mu$m) | $R_p$ ($\mu$m) | $\Delta R_p$ ($\mu$m) |
| 200 | 0,5 | 0,12 | 0,46 | 0,09 |
| 400 | 1 | 0,17 | 0,88 | 0,13 |
| 600 | 1,46 | 0,21 | 1,3 | 0,16 |
| 800 | 1,9 | 0,25 | 1,68 | 0,18 |
| 1000 | 2,33 | 0,27 | 2,1 | 0,2 |

La continuité diélectrique sous les zones actives peut être obtenue en utilisant une grille présentant une longueur jusqu'à environ 5 $\mu$m.

La réalisation d'une couche isolante enterrée 14 dans le substrat semiconducteur monocristallin 2, conformément à l'invention, permet d'obtenir une couche monocristalline 2a en silicium surmontant la couche isolante 14, exempte de défauts au niveau des zones actives des composants MOS qui seront réalisés ultérieurement. Dans cette couche semiconductrice monocristalline 2a, on pourra, ensuite, réaliser, comme représenté sur la figure 4, des îlots de silicium monocristallins tels que 15, isolés les uns des autres. Ces îlots pourront être obtenus de façon classique notamment par gravure de la couche monocristalline 2a en utilisant un masque approprié tel que 16. La réalisation des différents composants actifs du circuit intégré pourra alors avoir lieu dans les différents îlots monocristallins, de façon classique.

**Revendications**

1. Procédé de fabrication d'une couche isolante continue (14) enterrée dans un substrat semi-conducteur (2) dans lequel seront réalisées les zones actives des composants actifs d'un circuit intégré, consistant à réaliser un masque (6, 8) sur chacune des régions du substrat dans lesquelles seront réalisées les zones actives, à implanter des ions (10) d'oxygène ou d'azote dans le substrat (12), à travers le masque (6, 8) pour former respectivement une couche isolante (14) d'oxyde ou de nitrure continue et enterrée dans ledit substrat (2), par dispersion et diffusion latérales (F) des ions dans ledit substrat, l'énergie et la dose d'implantation étant respectivement au moins égales à 200 keV et $10^{18}$ ions/cm$^2$, à

chauffer le substrat pendant l'implantation (10) afin de faciliter ladite diffusion et à effectuer, après implantation, un recuit du substrat (2) implanté servant à renforcer, par diffusion latérale des ions implantés, la continuité de la couche isolante (14) et à recristalliser à partir desdites régions du substrat, les parties du substrat perturbées lors de l'implantation (10).

2. Procédé selon la revendication 1, caractérisé en ce que le masque présente une largeur allant de 0,5 à 5 μm.

3. Procédé selon la revendication 1 ou 2, caractérisé en ce que l'énergie d'implantation varie de 200 à 1 000 keV.

4. Procédé selon l'une quelconque des revendications 1 à 3, caractérisé en ce que la dose d'implantation varie de $10^{18}$ à $3 \cdot 10^{18}$ ions/cm$^2$.

5. Procédé de fabrication d'une couche isolante continue enterrée selon l'une quelconque des revendications 1 à 4, pour la réalisation sur un support isolant d'un composant actif d'un circuit intégré, caractérisé en ce qu'il comprend les étapes suivantes :
— réalisation d'une couche d'oxyde (4) sur le substrat (2) constituant l'oxyde de grille du composant,
— dépôt sur la couche d'oxyde de grille (4) d'une couche conductrice (6) servant à réaliser l'électrode de grille du composant,
— dépôt sur la couche conductrice d'une couche d'isolant (8),
— gravure de la couche déposée d'isolant (8) puis gravure de la couche conductrice (6) afin de réaliser la grille du composant,
— implantation ionique (10) d'oxygène ou d'azote dans le substrat pour former, par dispersion et diffusion latérales (F) dans ledit substrat (2) des ions implantés, une couche isolante (14) d'oxyde ou de nitrure continue ou enterrée dans ledit substrat (2), la couche conductrice (6) et la couche d'isolant (8) gravées servant de masque à cette implantation,
— chauffage du substrat pendant l'implantation ionique (10), et
— recuit du substrat, après l'implantation.

6. Procédé selon l'une quelconque des revendications 1 à 5, caractérisé en ce que le substrat (2) est réalisé en silicium monocristallin.

7. Procédé selon la revendication 6, caractérisé en ce que la couche conductrice (6) est une couche de silicium polycristallin.

8. Procédé selon la revendication 6 ou 7, caractérisé en ce que la couche déposée d'isolant (8) est une couche d'oxyde de silicium ou de nitrure de silicium.

9. Procédé selon l'une quelconque des revendications 1 à 8, caractérisé en ce que le recuit est réalisé à une température comprise entre 1 000 et 1 200 °C.

**Claims**

1. Process for the production of a buried insulating layer (14) in a semiconductor substrate (2) in which will be formed the active zones of the active components of an integrated circuit comprising producing a mask on the regions of the substrate in which the active zones will be formed and implanting the ions (10) of oxygen or nitrogen in the substrate (12) through the mask (6, 8) for forming, by lateral dispersion and diffusion (F) in said substrate of the ions, of a continuous insulating oxide or nitride layer (14) buried in said substrate (2), the energy and implantation dose being respectively at least equal to 200 keV and $10^{18}$ ions/cm$^2$, heating the substrate during implantation (10) in order to facilitate said diffusion and performing, following implantation, an annealing of the implanted substrate (2) serving to reinforce, by lateral diffusion of the implanted ions, the continuity of the insulating layer (4) and recrystallizing from said regions of the substrate those parts of the substrate disturbed during implantation (10).

2. Process according to claim 1, characterized in that the mask has a width between 0.5 and 5 μm.

3. Process according to claims 1 or 2, characterized in that the implantation energy varies from 200 to 1 000 keV.

4. Process according to any one of the claims 1 to 3, characterized in that the implantation dose varies from $10^{18}$ to $3 \cdot 10^{18}$ ions/cm$^2$.

5. Process for producing a buried continuous insulating layer according to any one of the claims 1 to 4 for producing an active component of an integrated circuit on an insulating support, characterized in that it comprises the following stages :
— producing an oxide layer (4) on substrate (2) constituting the gate oxide of the component,
— deposition on the gate oxide layer (4) of a conductive layer (6) for producing the gate electrode of the component,
— deposition on the conductive layer of an insulating layer (8),
— etching the deposited insulating layer (8) and then etching the conductive layer (6) in order to produce the gate of the component,
— ionic implantation (10) of oxygen or nitrogen in the substrate to form, by lateral dispersion and diffusion (F) in said substrate (2) of implanted ions, a continuous oxide or nitride insulating layer (14) or which is buried in said substrate (2), the etched conductive layer (6) and the etched insulating layer (8) serving as a mask for said implantation,

— heating the substrate during ionic implantation (10), and

— annealing the substrate after implantation.

6. Process according to any one of the claims 1 to 5, characterized in that the substrate (2) is made from monocrystalline silicon.

7. Process according to claim 6, characterized in that the conductive layer (6) is a polycrystalline silicon layer.

8. Process according to claims 6 or 7, characterized in that the deposited insulating layer (8) is a silicon oxide or silicon nitride layer.

9. Process according to any one of the claims 1 to 8, characterized in that annealing is carried out at a temperature between 1 000 and 1 200 °C.

## Patentansprüche

1. Verfahren zum Herstellen einer durchgehenden Isolierschicht (14), die in einem Halbleitersubstrat (2) vergraben ist, in der die aktiven Zonen der aktiven Bestandteile einer integrierten Schaltung ausgebildet werden, enthaltend : Aufbringen einer Maske (6, 8) auf Bereiche des Substrats, in welchen die aktiven Zonen ausgebildet werden sollen, Implantieren von Sauerstoff- oder Stickstoffionen (10) in das Substrat (12) durch die Maske (6, 8), um eine durchgehende isolierende Oxidschicht bzw. Nitridschicht (12) auszubilden, die in das Substrat vergraben ist, durch laterale Dispersion und Diffusion (F) von Ionen in das Substrat, wobei die Implantationsenergie und -dosis wenigstens gleich 200 keV bzw. $10^{18}$ Ionen/cm$^2$ betragen, Erwärmen des Substrats während der Implantation (10), um die genannte Diffusion zu erleichtern, und, nach der Implantation, Anlassen des implantierten Substrats (2), was dazu dient, durch Querdiffusion der implantierten Ionen den Zusammenhang der Isolierschicht (14) zu verstärken und ausgehend von den genannten Bereichen des Substrats jene Bereiche des Substrats zu rekristallilieren, die anlässlich der Implantation (10) gestört worden sind.

2. Verfahren nach Anspruch 1, dadurch gekennzeichnet, daß die Maske eine Größe hat, die zwischen 0,5 und 5 µm liegt.

3. Verfahren nach Anspruch 1 oder 2, dadurch gekennzeichnet, daß die Implantationsenergie zwischen 200 und 1 000 keV variiert.

4. Verfahren nach einem der Ansprüche 1 bis 3, dadurch gekennzeichnet, daß die Implantationsdosis zwischen $10^{18}$ und $3 \times 10^{18}$ Ionen/cm$^2$ variiert.

5. Verfahren zum Herstellen einer durchgehenden, vergrabenen Isolationsschicht nach einem der Ansprüche 1 bis 4 für die Ausbildung eines aktiven Bauelements einer integrierten Schaltung auf einem isolierenden Träger, dadurch gekennzeichnet, daß es die folgenden Schritte enthält :

— Ausbildung einer Oxidschicht (4) auf dem Substrat (2), die das Gitteroxid des Bauelements bildet,

— Aufbringen einer leitfähigen Schicht (6) auf der Gitteroxidschicht (4), die dazu dient, die Gitterelektrode des Bauelements auszubilden,

— Aufbringen einer Isolierschicht (8) auf der leitfähigen Schicht,

— Ätzen der aufgebrachten Isolierschicht (8) und anschließendes Ätzen der leitfähigen Schicht (6), um das Gitter des Bauelements auszubilden,

— ionisches Implantieren (10) von Sauerstoff oder Stickstoff in das Substrat, um durch Querdispersion und -diffusion (F) in das Substrat (2) implantierte Ionen, eine isolierende Oxid- oder Nitridschicht, die durchgehend oder in dem Substrat (2) begraben ist, auszubilden, wobei die vergrabene leitfähige Schicht (6) und die vergrabene Isolierschicht (8) als Maske für diese Implantation dienen,

— Erwärmen des Substrats während der ionischen Implantation (10), und

— Anlassen des Substrats nach dem Implantieren.

6. Verfahren nach einem der Ansprüche 1 bis 5, dadurch gekennzeichnet, daß das Substrat (2) aus monokristallinem Silicium besteht.

7. Verfahren nach Anspruch 6, dadurch gekennzeichnet, daß die leitfähige Schicht (6) eine Schicht aus polykristallinem Silicium ist.

8. Verfahren nach Anspruch 6 oder 7, dadurch gekennzeichnet, daß die aufgebrachte Isolierschicht (8) eine Schicht aus Siliciumoxid oder Siliciumnitrid ist.

9. Verfahren nach einem der Ansprüche 1 bis 8, dadurch gekennzeichnet, daß das Anlassen mit einer Temperatur ausgeführt wird, die zwischen 1 000 und 1 200 °C liegt.

FIG. 1

FIG. 2

FIG. 3

FIG. 4